# DEMANDE DE BREVET EUROPEEN

(11) **EP 4 661 066 A1**
(43) Date de publication de la demande: **10.12.2025**
(21) Numéro de dépôt: 25180972.9
(22) Date de dépôt: 05.06.2025
(51) Int. Cl.: H01L 21/768, H01L 23/522, H01L 23/528, H01L 23/532, H10B 63/10, H10B 63/00, H10N 70/00, H10N 70/20

(54) **STRUCTURE D'INTERCONNEXION A VIAS TRAVERSANT DES NIVEAUX METALLIQUES**

(30) Priorité: 05.06.2024 FR 2405920
(71) Demandeur: Commissariat à l'Energie Atomique et aux Energies Alternatives, 75015 Paris (FR)
(72) Inventeur: NIEBOJEWSKI, Heimanu, 38054 GRENOBLE Cedex 09 (FR)
(74) Mandataire: Santarelli

(57) **Abrégé**

Réalisation d'un dispositif microélectronique comprenant :
- un substrat revêtu d'un empilement comprenant une ou plusieurs pistes conductrices (106a, 106b, 106c, 106) d'un niveau « inférieur (M₁, Mₖ) », ce niveau inférieur étant revêtu d'une couche isolante (113) « intermédiaire », la couche isolante intermédiaire étant revêtue d'une ou plusieurs pistes conductrices (116a, 116b, 116c, 216) d'un niveau « supérieur (M₂, Mₖ₊₁) »,
- un élément conducteur (156b) traversant la couche isolante intermédiaire (113) et en contact avec une première piste conductrice (106b, 206) d'un niveau donné parmi le niveau supérieur (M₂, Mₖ₊₁) et le niveau inférieur (M₁, Mₖ) tout en étant isolé, par l'intermédiaire d'un espaceur (141e) isolant d'une deuxième piste conductrice (116b, 216) d'un autre niveau parmi le niveau inférieur et le niveau supérieur, l'espaceur isolant (141e) étant disposé entre la deuxième piste conductrice (116b ; 216) et l'élément conducteur (156b), l'élément conducteur (156b) ayant une extrémité « inférieure » (1562) prenant contact sur une première région (102A, 102), conductrice ou semi-conductrice du substrat ou de l'empilement, l'élément conducteur (156a ; 156b) traversant la première piste conductrice (106b, 206) et la deuxième piste conductrice (116b, 216) et étant entouré de l'espaceur (141e) isolant.

## Description

### DOMAINE TECHNIQUE ET ÉTAT DE LA TECHNIQUE ANTÉRIEURE

La présente demande se rapporte au domaine de la microélectronique et des circuits intégrés et concerne plus particulièrement la mise en œuvre d'une structure d'interconnexion, à éléments de connexion verticaux communément appelés « vias », ayant un agencement amélioré.

Les vias jouent un rôle crucial dans la performance des circuits électroniques, notamment en en ce qui concerne la densité d'interconnexion, les performances électriques.

Un via désigne un élément connexion électrique, disposé dans une ouverture et qui passe à travers une ou plusieurs couches ou régions d'un empilement. Cet élément de connexion est typiquement « vertical », c'est à dire qu'il s'étend orthogonalement ou sensiblement orthogonalement à un plan principal d'un substrat sur lequel les couches ou l'empilement sont formés. Un via permet ainsi de relier électriquement des régions appartenant à différents niveaux d'un dispositif microélectronique.

Dans certains cas, on souhaite pouvoir relier électriquement des régions appartenant à des niveaux non-adjacents disposés sur un substrat, c'est-à-dire séparés par un ou plusieurs niveaux intermédiaires d'éléments conducteurs ou de dispositifs intermédiaires. Par exemple, on peut souhaiter vouloir connecter une piste d'un troisième niveau métallique d'interconnexion, communément appelé « métal 3 » avec une piste métallique d'un niveau premier métallique d'interconnexion communément appelé « métal 1 », tout en évitant de prendre contact sur une piste du niveau métallique intermédiaire, ici un deuxième métallique d'interconnexion appelé « métal 2 ».

Pour éviter des connexions non désirées ou ne pas perturber le fonctionnement de dispositifs de niveaux intermédiaires traversés, on peut prévoir de former les éléments de connexion verticaux à une certaine distance des zones d'accès à ces dispositifs des niveaux intermédiaires, autrement dit en les contournant.

Néanmoins, il en résulte une réduction de la densité d'intégration.

Le document FR3030881 issu de la demanderesse, présente un procédé permettant d'isoler certaines portions latérales d'un via afin d'éviter un contact électrique non-désiré avec un ou plusieurs niveaux intermédiaires.

Il se pose donc le problème de réaliser des contacts permettant de relier électriquement des éléments de niveaux non adjacents sans que cela soit au détriment de la densité d'intégration.

### EXPOSE DE L'INVENTION

C'est par conséquent un but de la présente invention d'offrir un dispositif microélectronique comprenant :
- un substrat revêtu d'un empilement comprenant une ou plusieurs pistes conductrices d'un niveau dit « inférieur », ce niveau inférieur étant revêtu d'une couche isolante dite « intermédiaire », la couche isolante intermédiaire étant revêtue d'une ou plusieurs pistes conductrices d'un niveau dit « supérieur »,
- un élément conducteur traversant la couche isolante intermédiaire et étant en contact avec une première piste conductrice d'un niveau donné parmi le niveau supérieur et le niveau inférieur tout en étant isolé, par l'intermédiaire d'un espaceur isolant d'une deuxième piste conductrice d'un autre niveau parmi le niveau inférieur et le niveau supérieur, l'espaceur isolant étant disposé entre la deuxième piste conductrice et l'élément conducteur, l'élément conducteur ayant une extrémité dite « inférieure » prenant contact sur une première région, conductrice ou semi-conductrice du substrat ou de l'empilement,

l'élément conducteur traversant la première piste conductrice et la deuxième piste conductrice et étant entouré de l'espaceur isolant.

Avec un tel dispositif, et un tel agencement de structure d'interconnexion, on peut réaliser des connexions entre des étages différents et non adjacents tout en limitant l'encombrement, ce qui favorise l'obtention d'une meilleure densité d'intégration.

Le dispositif comprend en outre un deuxième élément conducteur ayant une extrémité inférieure prenant contact sur une deuxième région, conductrice ou semi-conductrice, du substrat ou de l'empilement, le deuxième élément conducteur traversant une piste conductrice du niveau donné ainsi que la couche isolante intermédiaire et une piste conductrice dudit autre niveau, le deuxième élément conducteur étant isolé, par l'intermédiaire d'un deuxième espaceur isolant, de la piste conductrice du niveau donné que le deuxième élément conducteur traverse, le deuxième élément conducteur étant en contact avec la piste conductrice de l'autre niveau qu'il traverse.

Avec un tel agencement de structure d'interconnexion, on peut réaliser des connexions indépendantes sur deux étages distincts superposés tout en améliorant la densité d'intégration.

Selon une possibilité de mise en œuvre du dispositif pour laquelle l'élément conducteur et le deuxième élément conducteur traversent chacun la première piste conductrice du niveau donné et traversent respectivement, la deuxième piste conductrice de l'autre niveau et une troisième piste conductrice de l'autre niveau distincte de la deuxième piste conductrice, la deuxième piste conductrice et la troisième piste conductrice s'étendant parallèlement ou sensiblement parallèlement à une première direction parallèle à un plan principal du substrat, la première piste conductrice s'étendant dans une deuxième direction orthogonale à la première direction, ou
- dans lequel, l'élément conducteur et le deuxième élément conducteur traversent chacun la première piste conductrice du niveau donné et chacun la deuxième piste conductrice de l'autre niveau.

Une telle structure s'adapte ainsi en particulier à la prise de contacts sur des pistes conductrices de niveaux distincts et ayant un agencement croisé ou de type communément appelé « crossbar » ou à une prise de contacts sur des pistes conductrices de niveaux distincts parallèles et superposées.

Selon une possibilité de mise en œuvre du dispositif, l'empilement comprend une couche isolante dite « inférieure » sur laquelle les une ou plusieurs pistes conductrices du niveau donné sont disposées, la première région étant disposée entre une zone du substrat et le niveau inférieur, l'élément conducteur traversant en outre la couche isolante inférieure.

Avantageusement, la première région est une région d'une couche semi-conductrice du substrat ou reposant sur le substrat.

Une telle structure permet d'établir un contact sélectif entre une couche semi-conductrice et un ou plusieurs niveaux métalliques d'interconnexion tout en limitant l'encombrement.

Selon une possibilité de mise en œuvre particulière, la première région peut former un ilot quantique. Une telle structure s'adapte ainsi avantageusement à l'adressage et/ou la polarisation d'un circuit quantique matriciel.

Selon une possibilité de réalisation particulière, la première région peut être une région de source ou de drain d'un transistor. Une telle structure s'adapte ainsi avantageusement à l'adressage et/ou la polarisation de transistors.

Selon un mode de réalisation particulier, l'espaceur isolant peut être à base d'un matériau apte à changer, de manière réversible, de résistance et/ou d'état entre une phase amorphe et une phase cristalline, notamment sous l'effet d'un courant électrique.

Une telle structure s'adapte ainsi avantageusement à la réalisation de circuits mémoires ReRAM ou PCMRAM.

Avantageusement, la première région peut être une région d'une couche semi-conductrice tandis que la deuxième région est une autre région de cette couche semi-conductrice.

La présente demande concerne également un procédé de réalisation d'un dispositif microélectronique tel que défini plus haut.

Selon un autre aspect, la présente demande concerne en outre un procédé pour la réalisation d'un dispositif microélectronique comprenant les étapes suivantes :
a) prévoir un substrat revêtu d'un empilement comportant une ou plusieurs pistes conductrices d'un niveau dit « inférieur», le niveau inférieur étant revêtu d'une couche isolante dite « intermédiaire », la couche isolante intermédiaire étant revêtue d'une ou plusieurs pistes conductrices d'un niveau dit « supérieur »,
b) formation d'une première ouverture et d'une deuxième ouverture dans l'empilement et traversant chacune une piste conductrice du niveau supérieur, la couche isolante intermédiaire, et une piste conductrice du niveau inférieur, la première ouverture exposant au moins une première portion et la deuxième ouverture exposant au moins une deuxième portion d'une ou plusieurs pistes conductrices du niveau supérieur, la première ouverture exposant en outre au moins une troisième portion et la deuxième ouverture exposant en outre au moins une quatrième portion, respectivement d'une ou plusieurs piste(s) conductrice(s) du niveau inférieur,
c) formation dans la première ouverture d'un premier espaceur isolant contre la première portion tout en laissant exposée la troisième portion et dans la deuxième ouverture d'un deuxième espaceur isolant contre la quatrième portion tout en laissant exposée la deuxième portion,
d) remplissage de la première ouverture et de la deuxième ouverture par au moins un matériau conducteur, de façon à former un premier élément conducteur et un deuxième élément conducteur, le premier élément conducteur en étant en contact de la troisième portion et étant isolé de la première portion par le biais du premier espaceur, le deuxième élément conducteur étant en contact avec la deuxième portion tout en étant isolé de la quatrième portion par le biais du deuxième espaceur.

Avantageusement, l'étape c), peut comporter au moins les étapes suivantes :
c1) dépôt d'une première fine couche isolante tapissant les parois de la première ouverture et de la deuxième ouverture,
c2) gravure partielle de la première fine couche isolante au niveau de la partie supérieure de la première ouverture, de sorte à exposer la première portion, tout en préservant la première fine couche isolante au niveau de la partie inférieure de la première ouverture ainsi que dans la deuxième ouverture,
c3) gravure partielle de la première portion, de sorte à former une cavité,
c4) dépôt d'une deuxième fine couche isolante tapissant les parois de la deuxième ouverture et de la première ouverture, et remplissant au moins partiellement la cavité,
c5) gravure(s) de la deuxième fine couche isolante, de sorte à préserver une région de la deuxième fine couche isolante dans la cavité.

Selon une possibilité de mise en après l'étape c1) et préalablement à l'étape c2), le procédé peut comprendre les étapes suivantes :
- dépôt d'au moins un matériau de bouchage de la première ouverture et de la deuxième ouverture,
- formation d'un masquage en regard de la deuxième ouverture et comportant une fenêtre en regard de la première ouverture,
- gravure, à travers ladite fenêtre, de l'au moins un matériau du bouchage dans une partie supérieure de la première ouverture tout en conservant le matériau du bouchage dans une partie inférieure de la première ouverture, le procédé comprenant en outre, après l'étape c2) et préalablement à l'étape c3) :
- retrait du matériau du bouchage dans la première ouverture et deuxième ouverture.

Selon une possibilité de mise en œuvre du procédé, la première fine couche isolante et la deuxième fine couche isolante peuvent être à base respectivement d'au moins un premier matériau et d'au moins un deuxième matériau différent du premier matériau, l'étape c5) de gravure(s) de la deuxième fine couche isolante étant effectuée par une gravure sélective du deuxième matériau vis-à-vis du premier matériau, suivie d'une gravure anisotrope de la première fine couche isolante.

Selon une possibilité de réalisation du procédé, le substrat ou l'empilement peut comporter une couche semi-conductrice revêtue d'au moins une couche isolante dite « inférieure », la couche isolante inférieure étant revêtue par la ou les pistes conductrices du niveau inférieur et dans lequel à l'étape b) de formation d'une première ouverture et d'une deuxième ouverture, la première ouverture et la deuxième ouverture sont formées de sorte à traverser la couche isolante inférieure jusqu'à atteindre la couche semi-conductrice.

Selon une mise en œuvre possible du procédé, la première ouverture et la deuxième ouverture peuvent être formées concomitamment à l'étape b) et le remplissage de la première ouverture et de la deuxième ouverture à l'étape d) est avantageusement réalisé de manière concomitante dans la première ouverture et dans la deuxième ouverture.

### BREVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
[Fig. 1] [Fig. 2] [Fig. 3] [Fig. 4A] [Fig. 4B] [Fig. 5] illustrent la réalisation de différents niveaux de pistes conductrices sur un substrat.
[Fig. 6] illustre la réalisation d'ouvertures de vias à travers différents niveaux de pistes conductrices.
[Fig. 7] [Fig. 8A] [Fig. 8B] [Fig. 9] [Fig. 10] [Fig. 11] [Fig. 12] [Fig. 13] [Fig. 14A] [Fig. 14B] illustrent une réalisation d'espaceurs isolants dans les ouvertures traversant les pistes, au moins un espaceur étant formé contre une piste d'un niveau supérieur, au moins un autre espaceur étant formé contre une piste d'un niveau inférieur.
[Fig. 15A] [Fig. 15B] [Fig. 15C] illustrent le remplissage des ouvertures de vias et une structure d'interconnexion ainsi obtenue.
[Fig. 16] illustre un exemple de structure d'interconnexion selon l'invention formée sur un substrat de type semi-conducteur sur isolant.
[Fig. 17] illustre une prise de contact d'une structure d'interconnexion sur des régions conductrices ou semi-conductrices qui peuvent être différentes.
[Fig. 18] illustre une structure d'interconnexion dotés de vias traversant un k^{ème} et un (k+1)^{ème} niveau métallique d'interconnexion.
[Fig. 19] illustre un exemple particulier de structure d'interconnexion formée de vias conducteurs traversant chacun une même piste conductrice d'un niveau supérieur et une même piste conductrice d'un niveau inférieur.
[Fig. 20A] [Fig. 20B] illustrent un exemple particulier de structure d'interconnexion pour contrôler une matrice d'ilots quantiques ou de qubits.
[Fig. 21] illustre une variante de structure d'interconnexion prenant contact de part et d'autre de régions d'un composant.
[Fig. 22A] [Fig. 22B] illustrent une structure d'interconnexion doté d'un via formant un élément mémoire et associé à un transistor.
[Fig. 23] illustre une structure d'interconnexion doté de via conducteur et susceptible de former, avec une piste conductrice qu'il traverse et un espaceur isolant agencé entre la piste et le via, un élément mémoire ReRAM ou PCRAM.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « dessus », « dessous », « inférieur », « supérieur », « juxtaposé », « superposé », « vertical », « horizontal » s'appliquent en considérant que la structure est orientée de la façon illustrée sur les figures.

### EXPOSÉ DÉTAILLÉ DE MODES DE RÉALISATION PARTICULIERS

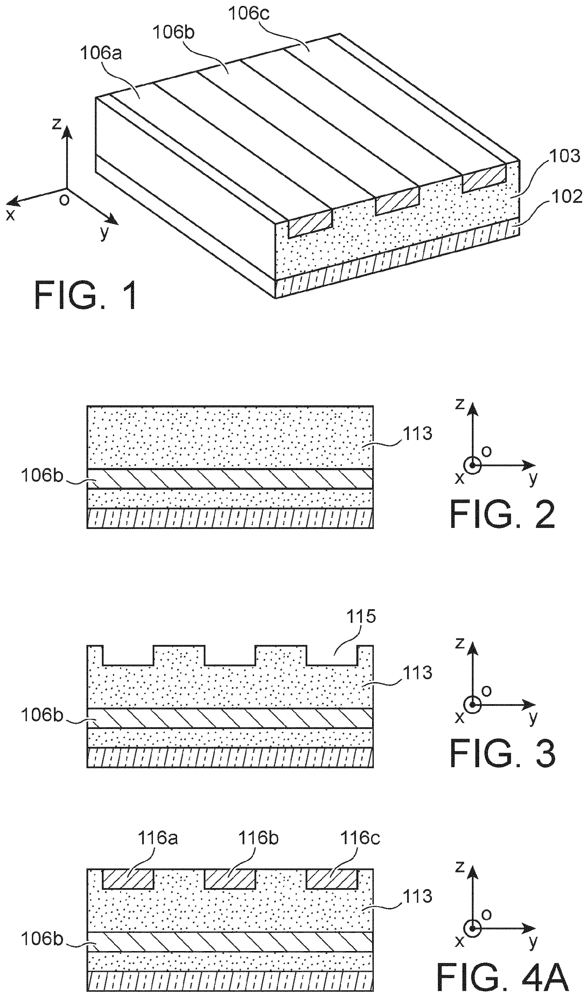

On se réfère tout d'abord à la figure 1 (donnant ici fois une vue en perspective) qui sert à illustrer une étape d'un exemple de procédé de fabrication d'une structure d'interconnexion.

Le matériau de départ du procédé comporte ici une couche 102 qui peut être conductrice et en particulier métallique, ou semi-conductrice, et sur laquelle on souhaite prendre contact, cette couche 102 appartenant à un substrat ou reposant sur un substrat (le substrat n'étant pas représenté sur cette figure).

La couche 102 est revêtue tout d'abord d'une couche isolante 103 dite « inférieure », par exemple à base de SiO₂ ou formée d'un empilement par exemple de type PMD (pour « Pre-Metal Dielectric », i.e. « diélectrique avant métal ») comportant une couche de SiO₂ déposée sur une couche d'arrêt de gravure par exemple en SiN.

Une ou plusieurs pistes conductrices sont formées sur la couche isolante 103 et appartiennent ici à un niveau métallique d'interconnexion dit « inférieur », par exemple correspondant au niveau inférieur métallique d'interconnexion M1 communément appelé « métal 1 ». Dans l'exemple particulier illustré, des pistes 106a, 106b, 106c, ici sous forme de lignes métalliques, par exemple à base de cuivre, sont en particulier réalisées.

Ces pistes 106a, 106b, 106c s'étendent ici principalement dans une direction parallèle à une direction y et à un plan principal du substrat. On appelle ici et dans toute la description le « plan principal » du substrat, un plan passant par le substrat et parallèle au plan [O ;x ;y ] d'un repère orthogonal [O ;x ;y ;z ] donné sur la figure 2 (ce plan étant également parallèle à la couche 102).

Un exemple de méthode de réalisation des pistes 106a, 106b, 106c utilise une technique de type Damascène où l'on réalise des tranchées, ici oblongues, dans la couche isolante 103, puis l'on effectue un remplissage des tranchées à l'aide d'un matériau métallique. Ce remplissage peut être suivi d'une étape de polissage CMP (« Chemical mechanical planarisation », i.e. « planarisation mécanochimique ») afin de retirer du matériau métallique en excédant débordant sur la couche isolante 103 en dehors des tranchées.

On peut ensuite réitérer une succession similaire d'étapes à celles décrites précédemment afin de former cette fois une ou plusieurs pistes conductrices 116a, 116b, 116c d'un niveau métallique d'interconnexion supérieur, correspondant par exemple ici à un deuxième niveau métallique d'interconnexion M2 communément appelé « métal 2 ».

Les pistes 106a, 106b, 106c du niveau inférieur M1 sont ainsi revêtues (figure 2 donnant cette fois une vue en coupe transversale) d'au moins une autre couche isolante 113 dite « intermédiaire », qui peut avoir une composition semblable à la couche isolante 103 inférieure, par exemple à base de SiO₂, et/ou peut être formée d'un empilement de plusieurs matériaux isolants tel qu'un empilement de SiN et de SiO₂.

On réalise ensuite des tranchées 115, ici oblongues, dans la couche isolante 113 intermédiaire (figure 3).

Puis, on effectue un remplissage des tranchées 115 à l'aide de matériau métallique. Ce remplissage peut être suivi d'une étape de polissage CMP (« Chemical mechanical planarisation », i.e. « planarisation mécanochimique ») afin de retirer du matériau métallique en excédant débordant sur la couche isolante 113 en dehors des tranchées.

Les tranchées 115, et les pistes 116a, 116b, 116c réalisées par remplissage de ces tranchées 115 sont prévues de sorte à s'étendre parallèlement à un plan principal du substrat.

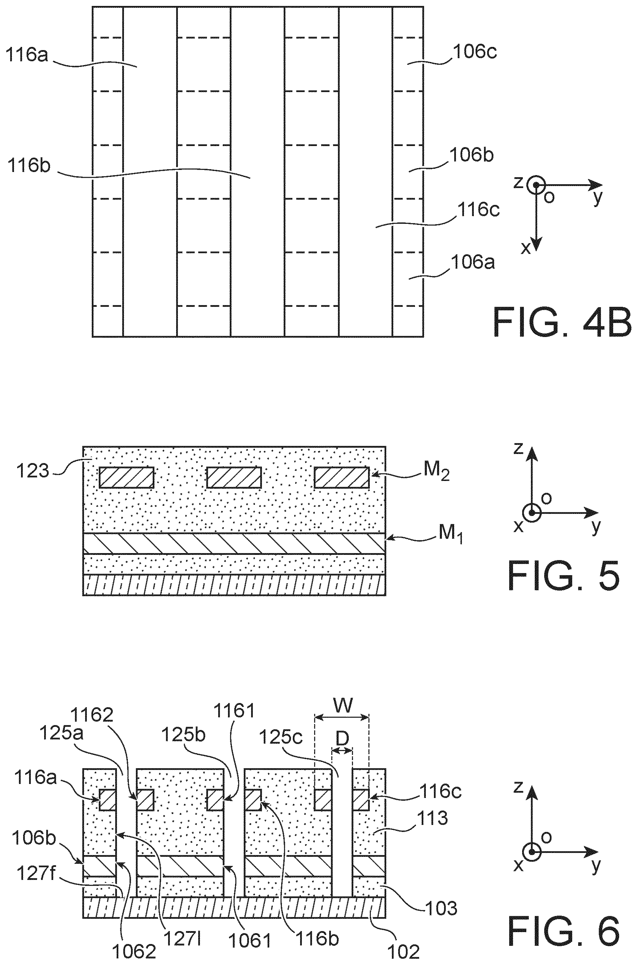

Dans cet exemple particulier illustré sur les figures 4A-4B (donnant respectivement une vue en coupe transversale et une vue de dessus), les pistes 116a, 116b, 116c sous forme de lignes métalliques, par exemple à base de cuivre , appartiennent à un niveau métallique d'interconnexion supérieur, en particulier au deuxième niveau métallique d'interconnexion M2 communément appelé « métal 2 ». Les pistes 116a, 116b s'étendent principalement dans une direction parallèle à une deuxième direction x, qui est donc orthogonale à celle dans laquelle les pistes 106a, 106b, 106c du niveau inférieur s'étendent.

Une couche isolante 123 dite « supérieure » peut être ensuite déposée (figure 5) sur le niveau M2 de pistes conductrices 116a, 116b, 116c. Là encore, la couche isolante 123 « supérieure » peut être par exemple à base d'oxyde de silicium ou d'un empilement de matériaux diélectriques avec une couche d'arrêt par exemple en SiN surmontée d'une couche de SiO₂.

On forme ensuite des ouvertures 125a, 125b, 125c dans l'empilement formé précédemment. Ces ouvertures 125a, 125b, 125c, qui s'étendent ici de préférence dans une direction verticale autrement dit orthogonalement au plan principal du substrat, exposent respectivement, et avantageusement traversent respectivement, les pistes conductrices 116a, 116b, 116c, du niveau M2 supérieur. Ces ouvertures 125a, 125b, 125c traversent également chacune la couche isolante intermédiaire 113 entre les niveaux M1 et M2, et exposent également chacune, et avantageusement traversent chacune, une piste conductrice 106a du niveau M1 inférieur. L'arrêt de la gravure des ouvertures 125a, 125b, 125c peut être effectué sur une couche située sous le niveau M1 inférieur.

En particulier, une ouverture 125b expose une portion 1161 de la piste conductrice 116b du niveau supérieur M₂ qu'elle traverse et une portion 1061 de la piste 106a du niveau inférieur M1 qu'elle traverse. Une ouverture 125a expose une portion 1162 de la piste conductrice 116a du niveau supérieur M2 qu'elle traverse et une portion 1062 de la piste 106a du niveau inférieur M1 qu'elle traverse.

Dans l'exemple particulier de procédé décrit ici, ces ouvertures 125a, 125b, 125c, traversent également la couche isolante 103 inférieure située entre le niveau M1 et la couche 102 semi-conductrice ou conductrice, et exposent la couche 102 semi-conductrice ou conductrice. On prévoit en particulier que le fond 127f des ouvertures 125a, 125b, 125c dévoile la couche 102 semi-conductrice ou conductrice.

La réalisation des ouvertures 125a, 125b, 125c comprend typiquement une étape de lithographie. Les ouvertures 125a, 125b, 125c ont ici un diamètre ou une largeur D (dimension mesurée parallèlement à l'axe y sur la figure 6), qui est prévu(e) inférieur(e) à la largeur W des pistes conductrices 116a, 116b, 116c, 106a, 106b, 106c, avec D par exemple de l'ordre de 40 nm, la largeur W des pistes étant comprise par exemple entre 100nm et 200nm. On prévoit typiquement W-D au moins égal à 60 nm

Une gravure sèche anisotrope peut être effectuée pour graver l'empilement et traverser ici avantageusement deux niveaux métalliques M1, M2. Par exemple, une gravure plasma à l'aide d'au moins un des composés suivants CCl₄, SiCl₄, Cl₂, HBr, CH₃COOH peut être employée pour traverser deux niveaux de pistes de cuivre.

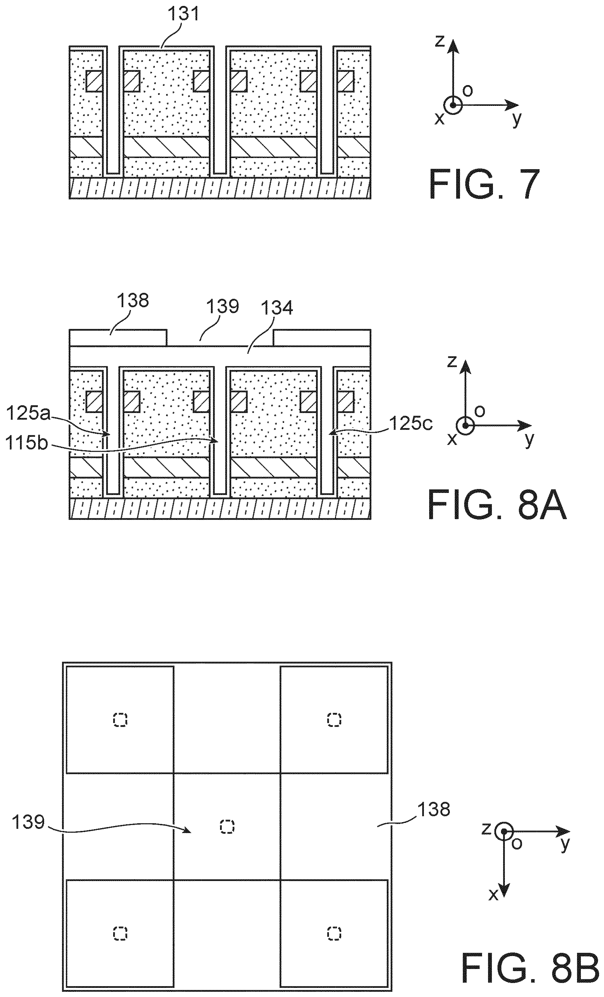

Ensuite, on dépose une première fine couche isolante 131, d'une épaisseur comprise par exemple entre 5 nm et 10 nm, tapissant les parois latérales 127l et de fond 127f des ouvertures 125a, 125b, 125c. Cette fine couche isolante 131 encore appelée « liner » peut être réalisée par dépôt conforme d'un matériau, diélectrique, par exemple choisi parmi les matériaux suivants : SiN, SiBCN, SiOCN, SiCO, HfO₂, TiO₂, Al₂O₃ (figure 7).

On réalise ensuite une protection ciblée de la partie supérieure d'une ou plusieurs ouvertures données parmi l'ensemble d'ouvertures 125a, 125b, 125c réalisées.

Pour cela, une méthode comprend une étape de bouchage de l'ensemble des ouvertures 125a, 125b, 125c, en déposant au moins un matériau 134 de remplissage des ouvertures 125a, 125b, 125c. Dans l'exemple de réalisation illustré sur la figure 8A, le matériau 134 de remplissage est déposé de sorte à combler les ouvertures 125a, 125b, 125c. Le matériau 134 de remplissage peut par exemple une couche de type SOC (pour « spin-on-carbon »), typiquement à base de matériau polymère, par exemple du PGMEA (Propylene glycol methyl ether acetate) avec une proportion de carbone typiquement supérieure 80%, et remplir les ouvertures 125a, 125b, 125c de préférence sur toute leur profondeur.

On forme ensuite un masquage 138, dans cet exemple sur une couche du matériau 134 de remplissage qui s'étend au-delà de l'embouchure des ouvertures 125a, 125b, 125c. Ce masquage 138 est réparti de manière ciblée en regard d'une ou plusieurs données 125a, 125c parmi les ouvertures 125a, 125b, 125c, remplies du matériau 134 de remplissage tout en conservant une ou plusieurs fenêtres 139, c'est-à-dire un ou plusieurs trous disposés en regard d'une ou plusieurs autres ouvertures parmi les ouvertures 125a, 125b, 125c remplies de matériau 134. Avantageusement, le masquage 138 formé par exemple d'une résine photosensible peut être disposé sur une couche anti-réfléchissante intermédiaire (non représentée) par exemple à base de silicium (SiARC), elle-même disposée sur le matériau 134 de remplissage.

On peut prévoir, au-dessus d'une succession de pistes le long d'une direction orthogonale à ces pistes, un bloc de masquage en regard d'une ou plusieurs pistes 116a, 116c tout en disposant une fenêtre 139 en regard d'une ou plusieurs autre(s) pistes 116b. Selon une possibilité d'agencement particulière du masquage 138, on prévoit d'agencer ce masquage en regard d'une piste sur deux. Ainsi, dans l'exemple de réalisation particulier illustré sur les figures 8A et 8B (donnant respectivement une vue en coupe transversale et une vue de dessus), on prévoit par exemple un agencement de fenêtres 139 en quinconce.

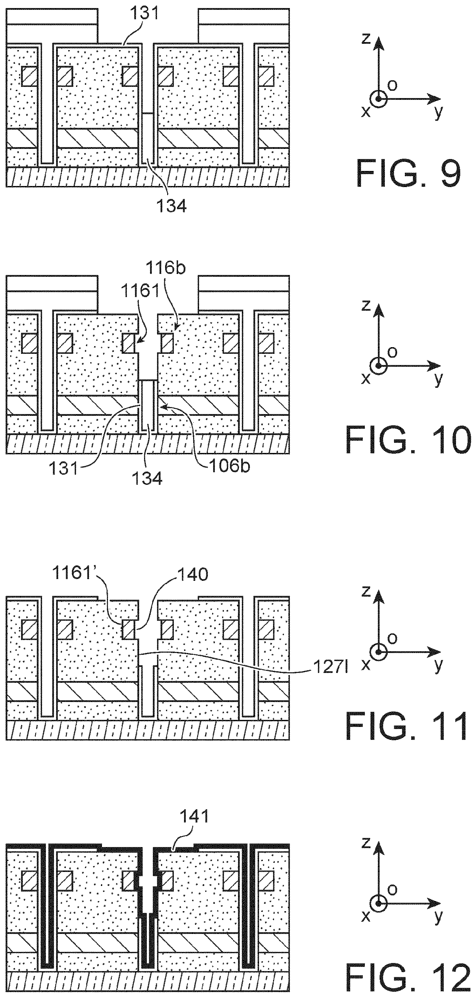

Un retrait partiel du matériau 134 de remplissage dévoilé par la ou les fenêtres 139 est ensuite réalisé. On retire en particulier une portion supérieure de matériau 134 de remplissage située dans la partie supérieure de la ou les ouvertures 125b concernée(s) et disposée(s) en regard d'une fenêtre 139. On grave ainsi le matériau 134 de remplissage de manière à n'en laisser que dans la partie inférieure de la ou les ouvertures 125b non recouvertes par le masquage 138 (figure 9). Cette gravure partielle du matériau 134 de remplissage peut être effectuée par plasma, par exemple un plasma fluoro-carbonné.

Ce retrait est suivi d'une gravure d'une partie de la première fine couche isolante 131 dévoilée par la ou les fenêtres 139 et non recouverte ou non protégée par le matériau 134 de remplissage. On retire ainsi la première fine couche isolante 131 dans la partie supérieure de la ou les ouvertures 125b disposée(s) en regard d'une fenêtre 139 (figure 10). Une gravure humide sélective isotrope peut être mise en œuvre pour effectuer ce retrait. Dans le cas particulier par exemple où la fine couche isolante 131 est en SiN, cette gravure peut être mise en œuvre à l'aide de H₃PO₄. A l'issue de cette étape, une ou plusieurs ouvertures 125a, 125c sont dotées d'une paroi de fond et de parois latérales entièrement revêtues par la fine couche 131, tandis qu'une ou plusieurs ouvertures 125b sont revêtues de la fine couche 131 uniquement au niveau de leur portion inférieure de sorte à recouvrir la piste 106a de niveau inférieur M1.

Une portion 1161 de piste conductrice 116b du deuxième niveau M2 est ainsi à nouveau exposée dans chaque ouverture 125b où ces retraits sont effectués, tandis que dans le prolongement au fond de cette ou ces même(s) ouverture(s) 125b, une piste 106a de niveau inférieur M1, ici traversée par cette ouverture 125b, reste protégée par le matériau 134 de remplissage et par la première fine couche isolante 131.

On peut effectuer ensuite une gravure partielle de portion 1161 exposée de la ou les piste 116b non protégée(s) par la première fine couche isolante 131.

Pour cela, on peut préalablement retirer, comme illustré sur la figure 11, le matériau 134 de remplissage ainsi que le masquage 138. Un tel retrait, notamment lorsque le matériau 134 est un polymère et le masquage 138 une résine photosensible peut être réalisé par un procédé d'élimination communément appelé « stripping » utilisant par exemple un dissolvant organique par exemple à base d'acétone.

La gravure partielle de portion 1161 exposée de la ou les piste 116b dans la partie supérieure de l'ouverture 125b est mise en œuvre de sorte à former une cavité 140 dans la paroi latérale 127l de l'ouverture 125b et exposant une portion gravée 1161' restante de la piste conductrice 116b. Une gravure humide sélective, par exemple au moyen d'une solution comprenant un mélange de peroxyde d'hydrogène (H₂O₂) et d'acide sulfurique (H₂SO₄) chauffé et communément appelée « hotSPM » ou de TMAH (acronyme de « TetraMethylAmmonium Hydroxide ») peut être en particulier utilisée lorsque la portion 1161 de piste conductrice 116b à graver est en polysilicium ou en métal tel que du cuivre. La gravure partielle vise à retirer une épaisseur de matériau conducteur de l'ordre de celle d'un liner, et en particulier d'une deuxième fine couche isolante destinée à être déposée ultérieurement. Cette deuxième fine couche isolante peut être prévue avec une épaisseur de l'ordre de celle de la première fine couche isolante 131 et/ou par exemple comprise entre 5 et 10 nm.

Ensuite (figure 12), on dépose la deuxième fine couche isolante 141 tapissant les parois latérales et le fond des ouvertures 125a, 125b, 125c. Cette deuxième fine couche isolante 141, d'épaisseur comprise par exemple entre 5 nm et 10 nm, peut être réalisée par dépôt conforme d'un matériau qui peut être diélectrique et choisi par exemple parmi les matériaux suivants : SiN, SiBCN, SiOCN, SiCO, HfO₂, TiO₂, Al₂O₃.

La fine couche isolante 141 peut être de même nature que la fine couche 131 ou avantageusement en un matériau différent de celui de la première fine couche isolante 131.

Selon un mode de réalisation particulier, la fine couche isolante 141 peut être une couche à résistivité variable destinée à former un élément de mémoire non-volatile, en particulier une couche telle qu'utilisée dans les RRAM ou ReRAM (« Resistive Random Access Memory ») dont le changement de résistance permet d'enregistrer une information. Dans ce cas, la fine couche isolante 141 peut être en particulier une couche d'oxyde (par exemple HfO₂, TiO₂, Al₂O₃) utilisée communément dans les structures OxRAM.

Selon un autre mode de réalisation particulier, la fine couche isolante 141 peut être à base de matériau à changement de phase, par exemple pour former une mémoire de type PCM (« Phase Change Memory », i.e. « mémoire à changement de phase »), susceptible de passer d'un état amorphe à un état cristallin et inversement. Par exemple, un matériau chalcogène tel que le GST (pour GeSbTe ou verre de chalcogénure) peut être utilisé.

On effectue le dépôt de la deuxième fine couche isolante 141 de sorte à tapisser les parois latérales et de fond des ouvertures 125a, 125b, 125c et remplir au moins partiellement la cavité 140 réalisée précédemment par gravure de la piste conductrice 125b dans l'ouverture 116b.

On réalise ensuite une gravure partielle de la deuxième fine couche isolante 141. Une telle gravure est réalisée de manière à retirer cette deuxième fine couche isolante 141 partout dans les ouvertures 116a, 116c et dans l'ouverture 116b de préférence tout en la conservant au moins partiellement dans la cavité 140 précédemment formée par gravure de la piste 116b. Une gravure sélective par rapport au matériau de la première fine couche isolante 131 peut être effectuée lorsque la deuxième fine isolante 141 est à base d'un matériau différent. Une telle étape de gravure peut être réalisée par gravure humide, par exemple à l'aide de HF ou par gravure sèche, par exemple à l'aide d'un plasma de type CF₄/Ar, voire d'une combinaison des deux types de gravures.

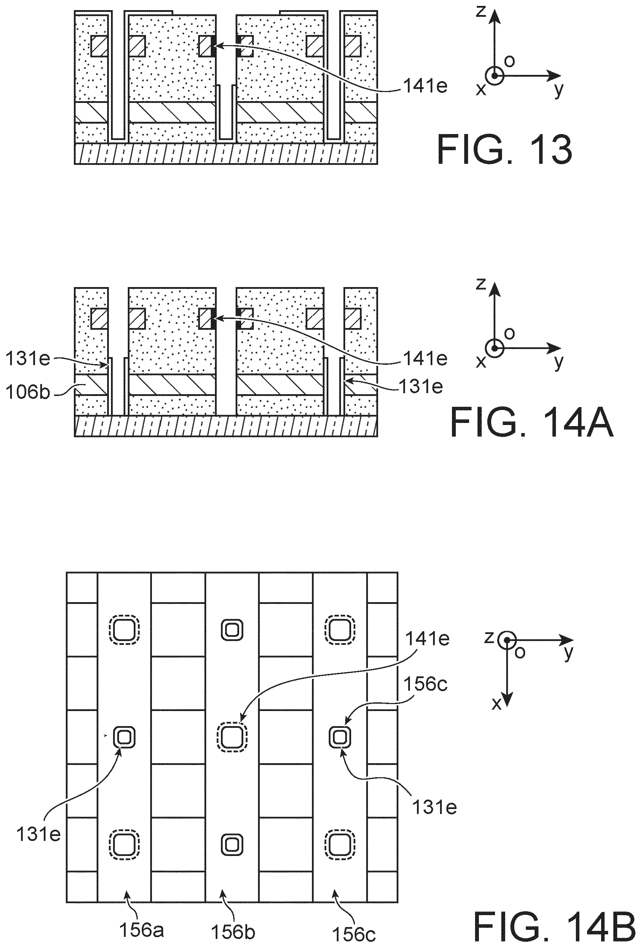

Ainsi, on conserve une partie de la deuxième fine couche isolante 141 au moins contre la piste conductrice 116b de deuxième niveau M2 exposée par l'ouverture 125b. La partie conservée de la deuxième fine couche isolante 141 forme alors un bouchon isolant, également appelé « espaceur » 141e, disposé contre la portion exposée de la piste conductrice 116b (figure 13).

On réalise ensuite une étape de gravure de la première fine couche isolante 131, de sorte à ne conserver que des régions de la première fine couche isolante 131 dans la partie inférieure des ouvertures 125a, 125c, dans lesquelles la deuxième fine couche 141 a été entièrement retirée et qui ne comportent pas d'espaceur 141e formé à partir d'une telle couche 141. Les régions de la première fine couche isolante 131 conservées forment alors un bouchon isolant appelé « espaceur » 131e contre des portions de la piste conductrice 106a (figure 14A et 14B donnant respectivement une vue en coupe transversale et une vue de dessus).

Dans un cas, où les fines couches isolantes 131, 141 sont de nature différente, on forme le ou les espaceurs 131e en effectuant une étape de gravure anisotrope de la première fine couche isolante 131e. Cette gravure est poussée sous le deuxième niveau M2 et de préférence sans atteindre le niveau inférieur M1.

Une telle étape de gravure peut être réalisée par gravure sèche, par exemple à l'aide d'un plasma de type CF₄/O₂.

En variante, dans le cas où les fines couches 131 et 141 sont de même nature et ont des compositions identiques, le retrait partiel de la deuxième fine couche 141 et de la première fine couche 131 pour former les espaceurs 131e, 141e peut être effectué en une seule gravure plasma anisotrope de ces fines couches 131, 141.

On effectue ensuite un dépôt de matériau conducteur 150 afin de remplir les ouvertures 125a, 125b, 125c et former des éléments conducteurs 156a, 156b, 156c verticaux communément appelés « vias ». Un dépôt métallique conforme d'un ou plusieurs des matériaux suivants : Ti, TiN, W, Cu, Ta, Co, Ru, peut être par exemple réalisé. Un tel dépôt est typiquement suivi d'une étape de planarisation CMP de matériau(x) en excédant susceptible(s) de déborder au-delà de l'embouchure des ouvertures 125a, 125b, 125c.

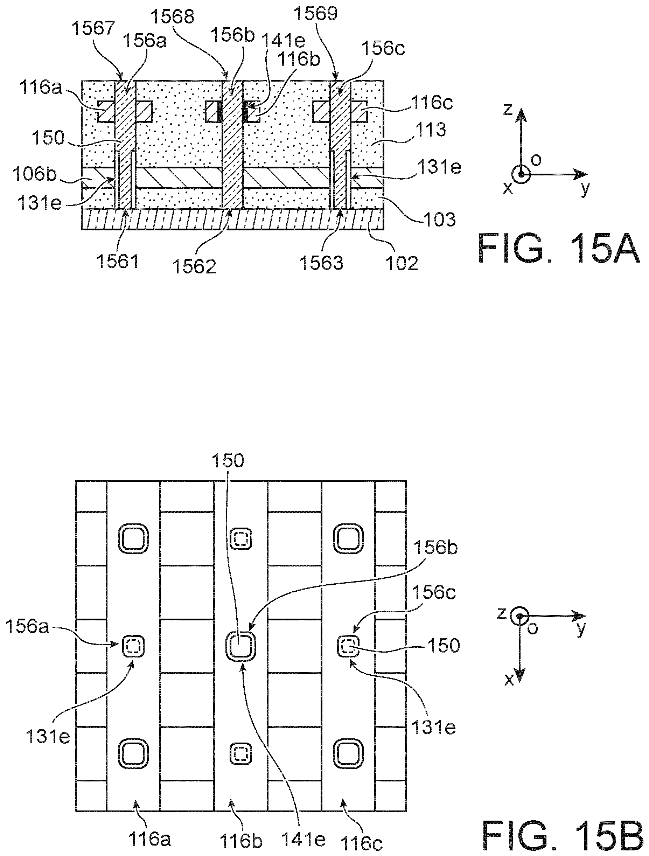

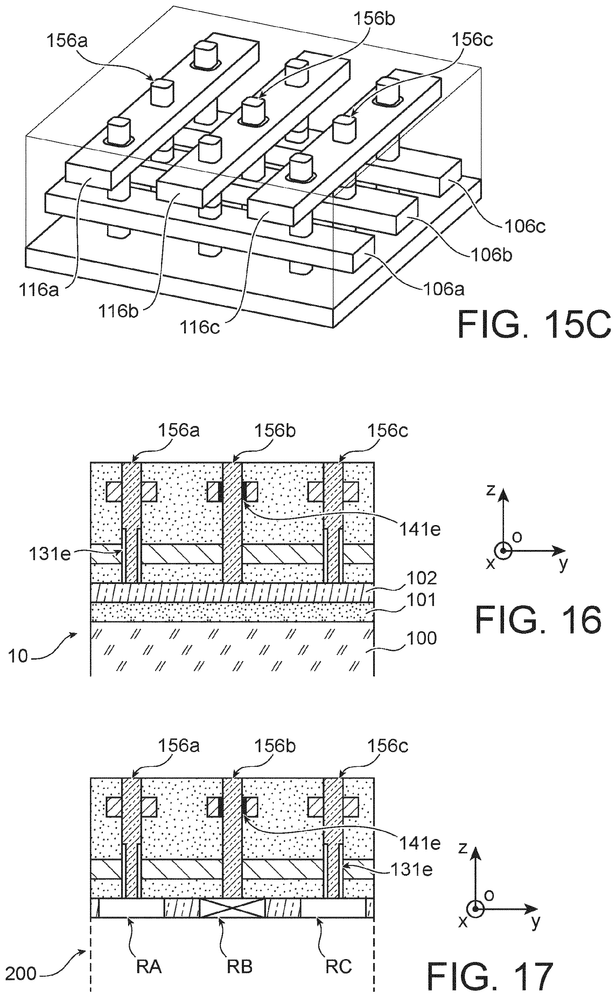

On obtient alors une structure d'interconnexion telle qu'illustrée sur les figures 15A-15C (donnant respectivement une vue en coupe transversale, une vue de dessus et une vue en perspective).

La structure est pourvue d'éléments conducteurs 156a, 156b, 156c ou « vias » traversant chacun la couche isolante intermédiaire 113 entre les niveaux M2 et M1, et la couche isolante 103 située sous le niveau inférieur M1, pour prendre contact par le biais de leurs extrémités inférieures respectives 1561, 1562, 1563 sur la couche 102 conductrice ou semi-conductrice.

Parmi ces éléments conducteurs 156a, 156b, 156c, les élément conducteurs 156a, 156c donnés sont en contact respectivement avec des pistes conductrices 116a, 116c du niveau supérieur M2 qu'ils traversent respectivement tout en étant isolés, par l'intermédiaire de l'espaceur isolant 131e, d'une même piste conductrice 106a du premier niveau M1 qu'ils traversent chacun également.

Au moins un autre élément conducteur 156b et est en contact avec la piste conductrice 106a du niveau inférieur M1 qu'il traverse tout en étant isolé, par l'intermédiaire de l'espaceur isolant 141e, d'une piste conductrice du deuxième niveau M2 qu'il traverse également.

Au niveau de chaque piste conductrice de niveau inférieur M1 ou de niveau supérieure M2, les éléments conducteur 156a, 156b, 156c sont ici entourés et typiquement entièrement entourés de matériau de cette piste conductrice.

Les espaceurs 131e, 141e réalisent avantageusement un contour fermé isolant formant un manchon ou une bague autour de leur élément ou via conducteur traversant respectif lui-même typiquement entièrement entouré par le matériau conducteur de la piste que l'élément ou via conducteur traverse.

Typiquement, les éléments conducteur 156a, 156b, 156c sont dotés d'extrémités supérieures respectives 1567, 1568, 1569 qui s'étendent au-delà du niveau M2 supérieur et dépassent chacun d'une piste conductrice de niveau M2 supérieur et d'extrémités inférieures respectives 1561, 1562, 1563, qui s'étendent au-delà du niveau M1 inférieur et dépassent chacun d'une piste conductrice de niveau inférieur M1 pour atteindre une zone entre le substrat et le niveau inférieur M1.

On réalise ici une structure d'interconnexion qui permet de réaliser des connexions inter-niveaux tout en évitant d'interconnecter des pistes de niveaux M1, M2 directement adjacents ou voisins et en ayant un agencement compact favorable à une densité d'intégration importante.

Une telle structure d'interconnexion à vias traversants permet un gain de densité d'intégration importante. On peut éviter ici, à l'aide des espaceurs 131e, 141e, de contourner un niveau métallique auquel on ne souhaite pas être connecté électriquement.

Dans l'exemple de réalisation qui vient d'être décrit, les éléments conducteurs 156a, 156b, 156c ont des extrémités inférieures respectives 1561, 1562, 1563 prenant contact avec une même couche 102 conductrice ou semi-conductrice.

Cette couche 102 peut être avantageusement une couche semi-conductrice communément appelée « couche active » d'un substrat ou reposant sur un substrat et dans laquelle des composants ou parties de composants, par exemple tels que des transistors, sont réalisés ou destinés à être réalisés.

Ainsi, un exemple de réalisation particulier prévoit, comme structure de départ pour réaliser un procédé du type de celui décrit précédemment, un substrat 10 de type semi-conducteur sur isolant tel qu'illustré sur la figure 16, par exemple de type SOI (SOI pour « Silicon On Insulator » ou « Silicium sur isolant ») doté d'une couche 100 de support semi-conductrice, par exemple en silicium, revêtue d'une couche isolante 101, par exemple en SiO₂, et communément appelée de BOX (« buried-oxide » ou oxyde enterré), la couche isolante 101 étant elle-même revêtue de la couche semi-conductrice 102 formant ici la couche superficielle du substrat. Une telle couche semi-conductrice superficielle peut être par exemple en silicium, ou en SiGe, ou Ge.

Une variante de structure est donnée sur la figure 17, avec un bloc 200 en trait discontinu représentant de manière schématique un substrat revêtu d'une couche ou de plusieurs couches ou d'un empilement sur lequel affleurent des régions RA, RB, RC, à contacter. Ces régions RA, RB, RC sont typiquement conductrices ou semi-conductrices mais de compositions différentes entre elles. Par exemple, une ou plusieurs régions est ou sont, en un premier matériau, métallique ou semi-conducteur tandis qu'au moins une autre région est en un deuxième matériau, par exemple semi-conducteur et différent du premier matériau. Sur ces régions RA, RB, RC, les extrémités inférieures respectives 1561, 1562, 1563 des éléments conducteurs 156a, 156b, 156c prennent respectivement contact.

Dans l'exemple décrit précédemment, les vias formés traversent des pistes conductrices d'un niveau inférieur M1 qui peut être le premier niveau métallique d'interconnexion et d'un niveau supérieur M2 qui peut être le deuxième niveau métallique d'interconnexion. Toutefois, un procédé semblable peut être mis en œuvre sur d'autres niveaux métalliques d'interconnexion.

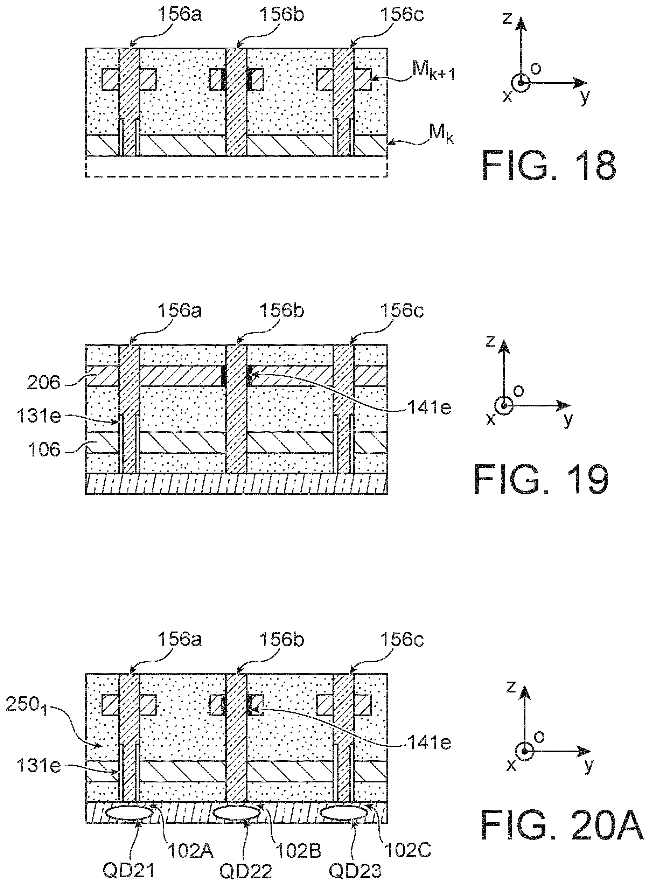

Ainsi, dans la variante de réalisation illustrée sur la figure 18, les éléments conducteurs 156a, 156b, 156c, traversent chacun une piste conductrice d'un (k+1)^{ième} niveau (avec k un entier supérieur à 1) et une piste d'un k^{ième} niveau tout en étant à la fois en contact électrique avec une piste conductrice du k^{ième} niveau et isolée d'une piste du (k+1)^{ième} niveau ou en étant à la fois en contact électrique avec une piste du (k+1)^{ième} niveau et isolée d'une piste du k^{ième} niveau.

Dans l'exemple de procédé décrit précédemment en lien avec les figures 1 à 15A-15C, les éléments conducteurs 156a, 156b, 156c traversent des pistes conductrices d'un niveau supérieur qui sont orthogonales à une ou plusieurs pistes d'un niveau donné inférieur. Une variante de réalisation illustrée sur la figure 19 prévoit éléments conducteurs 156a, 156b, 156c traversant chacun une même piste conductrice 216 d'un niveau supérieur et chacun une même piste conductrice 106 d'un niveau donné inférieur, les pistes conductrices 116 et 106 s'étendant principalement dans des directions respectives parallèles entre elles et sur la figure 19 parallèles à l'axe y du repère orthogonal [O ;x ;y ;z].

Une structure d'interconnexion telle que décrite précédemment s'adapte tout particulièrement à un adressage de qubits, notamment de qubits de spin prévus dans des régions semi-conductrices formant des boites quantiques. Un adressage parallèle en lignes et en colonnes d'une matrice de boites quantiques QDs peut être réalisé à l'aide d'une structure d'interconnexion telle que décrite précédemment tout en limitant le nombre de signaux de contrôle nécessaires.

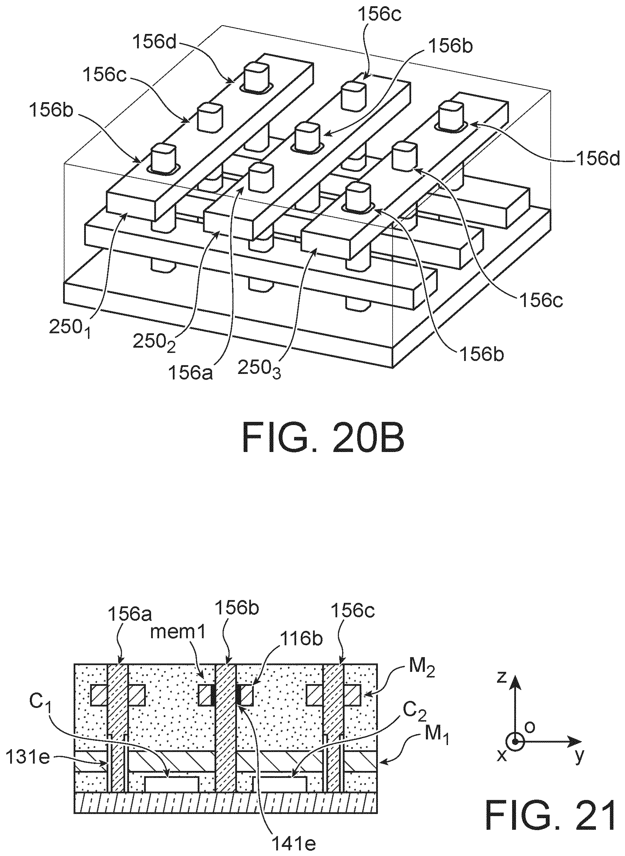

Ainsi, dans un exemple de réalisation particulier illustré sur les figures 20A et 20B, les éléments conducteurs 156a, 156b, 156c ont leurs extrémités inférieures prenant contact respectivement avec des régions 102A, 102B, 102C, typiquement semi-conductrices et par exemple d'une même couche semi-conductrice et formant chacune une boite quantique associé à un Qubit QD21, QD22, QD23.

Un élément conducteur 156a, permet de relier électriquement une piste conductrice 116a d'un niveau supérieur M2 avec une région 102A formant un Qubit QD21 tout en étant isolé d'une piste conductrice 106 du niveau inférieur M1 par l'intermédiaire d'un espaceur isolant 131e. Un autre élément conducteur 156b, permet de relier électriquement une piste conductrice 106a du niveau inférieur M1 avec une région 102B formant un autre Qubit QD22 tout en étant isolé d'une piste conductrice 116b du niveau supérieur M2 par l'intermédiaire d'un espaceur isolant 141e.

Un agencement particulier en quinconce des éléments conducteurs ou vias traversants peut être prévu pour le réseau bidimensionnel de Qubits.

Un tel exemple d'agencement en quinconce est illustré sur la figure 20B, où les éléments conducteurs ont un agencement matriciel en différentes rangées 250₁,205₂, 250₃,..., 250ₘ, chaque rangée étant formé d'une alternance d'éléments conducteur 156b, 156d connectés au niveau métallique inférieur M1 et isolés du niveau métallique supérieur M2 et d'éléments conducteur 156a, 156c connectés au niveau métallique supérieur M2 et isolés du niveau métallique inférieur M1, cette alternance étant décalée d'une rangée à l'autre. Ainsi, une première rangée 250₁ comporte à son extrémité un élément conducteur 156b connecté au niveau métallique inférieur M1 et isolé du niveau métallique supérieur M2. Une rangée 250₂ voisine suivante et typiquement de même nombre de Qubits que la première rangée 250₁, comporte à son extrémité un élément conducteur 156a cette fois connecté au niveau métallique supérieur M2 et isolé du niveau métallique inférieur M1, tandis qu'une rangée 250₃ voisine de la suivante 250₂ et typiquement de même nombre de Qubits que les rangées 250₁, 250₂, comporte à son extrémité un élément conducteur 156b isolé du niveau métallique supérieur M2 tout en étant connecté au niveau métallique inférieur M1. Une même rangée 250₂ peut ainsi comporter une alternance de Qubits QD21, QD23 commandés par une piste de niveau métallique supérieur et une piste de qbits QD22 commandé par une piste de niveau métallique supérieur.

Un tel agencement est propice à la mise en œuvre d'une correction d'erreur par exemple de type « Surface Code » telle que proposée par Fowler et al. dans le document « Surface codes: Towards practical large-scale quantum computation »., Phys review A, 2012.

Dans l'exemple de réalisation illustré sur la figure 21, une structure d'interconnexion d'un type tel que décrit précédemment peut être adaptée à l'adressage et/ou à la polarisation d'un ou plusieurs circuits ou composants C₁, C₂ par exemple de transistors, capacités, résistances ou dotés de transistors formés au moins partiellement dans la couche 102 sur laquelle les éléments conducteurs 156a, 156b, 156c. Là encore, un ou plusieurs éléments conducteurs 156a, 156c isolés d'un niveau inférieur M1 tout en étant couplés à un niveau M2 supérieur, tandis qu'un ou plusieurs autre(s) élément(s) conducteur(s) 156b sont couplés au niveau inférieur M1 tout en étant isolés du niveau M2 supérieur. Un mode de réalisation particulier, ici représenté sur la figure 21 prévoit en outre qu'au moins élément conducteur 156b, ici couplé au niveau inférieur M1, forme avec une piste conductrice 156b du deuxième niveau M2 qu'il traverse, un élément mem1 de mémoire non-volatile.

Dans ce cas, l'espaceur 141e isolant qui est agencé entre cette piste conductrice 116b et l'élément conducteur 156b traversant, est prévu avec un matériau spécifique, en particulier un matériau dont la résistance est susceptible d'être modifiée de manière réversible sous l'effet d'un courant électrique ou bien un matériau dont l'état est susceptible d'être modifié de manière réversible pour passer d'un état amorphe à un état cristallin et d'un état cristallin à un état amorphe.

L'élément conducteur 156b et la piste conductrice 116b forment ainsi respectivement une première électrode et une deuxième électrode entre lesquelles le matériau à changement de phase et/ou résistance variable est disposé. L'élément mem1 de mémoire non-volatile peut être ainsi par exemple un élément de mémoire ReRAM (pour "Resistive Random-Access Memory", i.e. Mémoire vive à accès aléatoire résistive), en particulier un élément mémoire OxRAM. Dans ce cas l'espaceur isolant 141e peut être par exemple prévu à base d'au moins un des matériaux suivants : HfO₂, TiO₂, Al₂O₃, TaOₓ, ZrOₓ.

En variante, l'élément mem1 de mémoire non-volatile peut être de type PCRAM (pour «°Phase-Change Random Access Memory », i.e. Mémoire à accès aléatoire et Changement de Phase). Dans ce cas l'espaceur isolant 141e peut être par exemple prévu à base d'un matériau Chalcogénure par exemple tel que le GST (GeSbTe).

La mise en œuvre de tels éléments mémoire ReRAM ou PCRAM peut permettre de former par exemple des structures de type 1T1R où un transistor est associé avec un tel élément mémoire formé au niveau d'un via.

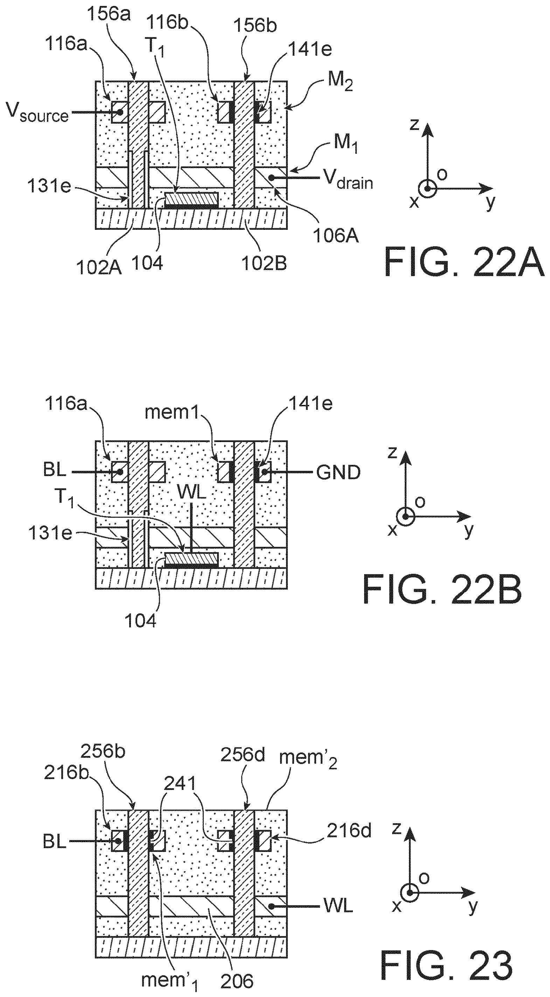

Un exemple de réalisation particulier d'une telle structure illustré sur les figures 22A-22B prévoit des éléments conducteurs 156a, 156b verticaux traversants sont agencés de part et d'autre d'une grille 104 d'un transistor T₁ et prennent contact respectivement sur une région 102A parmi une région de source et une région de drain du transistor T₁ et sur une deuxième région 102B parmi une région de drain et une région de source distincte de la première région.

Sur la figure 22A, un mode de fonctionnement particulier est illustré. L'élément conducteur 156a connecté au niveau M2 tout en étant isolé du niveau M1 par l'intermédiaire de son espaceur 131e permet d'appliquer un potentiel de polarisation Vsource à la région 102A du transistor T1 qui dans cet exemple particulier forme une région de source. Ce potentiel de polarisation est ici véhiculé par la piste conductrice 116a avec laquelle l'élément conducteur 156a est en contact et qu'il traverse. L'autre élément conducteur 156b connecté au niveau M1 tout en étant isolé du niveau supérieur M2 par l'intermédiaire de son espaceur 141e permet d'appliquer un potentiel de polarisation Vdrain à la région 102B du transistor T1 qui, dans cet exemple particulier, forme une région de drain. Ce potentiel de polarisation est ici véhiculé par la piste conductrice 106a que les deux éléments 156a, 156b traversent mais avec laquelle seul l'autre élément 156b est connecté électriquement. On se sert ainsi d'une telle structure d'interconnexion pour polariser un transistor T₁ (la polarisation de la grille 104 n'étant ici pas représentée) tout en limitant l'encombrement. L'élément conducteur 156b peut former avec une piste conductrice 116b de niveau M2 un élément de mémoire volatile qui, dans ce mode de fonctionnement n'est pas utilisé.

La figure 22B permet d'illustrer un autre mode de fonctionnement où la piste conductrice 116a forme une ligne de bit BL pour l'adressage d'une structure mémoire, connectée ici à la région 102A du transistor T₁, tandis qu'une ligne de mot WL pour l'adressage de la structure mémoire est connectée ici à la grille 104 du transistor T₁, la région 102B du transistor étant reliée en série avec un élément mem1 de mémoire non-volatile, formé par l'élément conducteur 156b, son espaceur isolant 141e, et la piste conductrice 116b traversée par cet élément conducteur 156b et contre laquelle l'espaceur isolant 141e est agencé. Une cellule mémoire de type 1T1R est formée ainsi par le transistor T1 en série avec l'élément mémoire mem1, un bit pouvant être stocké par le biais de l'espaceur 141e en fonction de son état, et le transistor T1 servant ici de transistor de sélection encore appelé « sélecteur ».

Un autre exemple de structure donné sur la figure 23, prévoit cette fois des éléments conducteurs 256b, 256d verticaux traversant respectivement une première piste conductrice 216b et une deuxième piste conductrice 216d de même niveau que la première tout en étant isolées respectivement par l'intermédiaire d'espaceurs isolants 241e de ces pistes 216b, 216d.

Les éléments conducteurs 256b, 256d verticaux traversent en outre chacun une même troisième piste conductrice 206 de niveau différent et sont connectés électriquement à cette même troisième piste conductrice 206.

Là encore, des éléments mem'1, mem'2 de mémoire non-volatile peuvent être chacun formés par une piste conductrice horizontale 216b (resp. 216d) formant une première électrode, un espaceur 241e formant une couche de mémorisation, et un élément conducteur 256b vertical (resp. 216d) formant une première électrode.

Les pistes 216b et 216d peuvent servir ici par exemple de lignes de bits BL, tandis que la piste conductrice 206 de niveau différent forme par exemple une ligne de mot WL.

Une structure d'interconnexion telle que décrite précédemment trouve des applications notamment dans la polarisation de circuits 3D avec des niveaux superposés de couches semi-conductrices, dans la réalisation de circuits mémoires, dans l'adressage de circuits matriciels, en particulier de matrices mémoires ou de matrice de boites quantiques ou de qubits.

## Revendications

1. Dispositif microélectronique comprenant :
- un substrat revêtu d'un empilement comprenant une ou plusieurs pistes conductrices (106a, 106b, 106c, 106) d'un niveau dit « inférieur (M₁, Mₖ) », ce niveau inférieur étant revêtu d'une couche isolante (113) dite « intermédiaire », la couche isolante intermédiaire étant revêtue d'une ou plusieurs pistes conductrices (116a, 116b, 116c, 216) d'un niveau dit « supérieur (M₂, Mₖ₊₁) »,
- un élément conducteur (156b) traversant la couche isolante intermédiaire (113) et en contact avec une première piste conductrice (106b) du niveau inférieur tout en étant isolé, par l'intermédiaire d'un espaceur (141e) isolant d'une deuxième piste conductrice, la deuxième (116b, 206) piste conductrice étant du niveau supérieur, ledit espaceur isolant (141e) étant disposé entre la deuxième piste conductrice (116b) et ledit élément conducteur (156b), ledit élément conducteur (156b) ayant une extrémité dite « inférieure » (1562) prenant contact sur une première région (102A, 102), conductrice ou semi-conductrice du substrat ou de l'empilement,
ledit élément conducteur (156a ; 156b) traversant la première piste conductrice (106b, 206) et la deuxième piste conductrice (116b, 216) et étant entouré dudit espaceur (141e) isolant, le dispositif comprenant en outre :
- un deuxième élément conducteur (156a) ayant une extrémité inférieure (1561) prenant contact sur une deuxième région (102A, 102), conductrice ou semi-conductrice, du substrat ou de l'empilement, le deuxième élément conducteur (156a) traversant une piste conductrice du niveau supérieur ainsi que la couche isolante intermédiaire (113) et une piste conductrice du niveau inférieur, le deuxième élément conducteur (156a) étant isolé, par l'intermédiaire d'un deuxième espaceur (131e) isolant, de ladite piste conductrice du niveau inférieur que le deuxième élément conducteur traverse, le deuxième élément conducteur étant en contact avec ladite piste conductrice du niveau supérieur qu'il traverse.

2. Dispositif électronique selon la revendication 1, dans lequel l'élément conducteur (156b) et le deuxième élément conducteur (156a) traversent chacun la première piste conductrice (206) du niveau inférieur et traversent chacun la deuxième piste conductrice (116b) du niveau supérieur.

3. Dispositif électronique selon la revendication 1,
- dans lequel l'élément conducteur (156b) et le deuxième élément conducteur (156a) traversent chacun la première piste conductrice (106b) du niveau inférieur et traversent respectivement, la deuxième piste conductrice (116b) du niveau supérieur et une troisième piste conductrice (116a) du niveau supérieur distincte de la deuxième piste conductrice, la deuxième piste conductrice (116b) et la troisième piste conductrice (116a) s'étendant parallèlement ou sensiblement parallèlement à une première direction parallèle à un plan principal du substrat, la première piste conductrice s'étendant dans une deuxième direction orthogonale à la première direction, ou
- dans lequel, l'élément conducteur (156b) et le deuxième élément conducteur (156a) traversent chacun la deuxième piste conductrice du niveau supérieur et respectivement la première piste conductrice et une troisième piste conductrice du niveau inférieur.

4. Dispositif électronique selon l'une des revendications précédentes, dans lequel l'empilement comprend une couche isolante (103) dite « inférieure » sur laquelle lesdites une ou plusieurs pistes conductrices (106a) du niveau inférieur (M₁, Mₖ) sont disposées, la première région (102A, 102) étant disposée entre une zone du substrat et ledit niveau inférieur, l'élément conducteur (156b) traversant en outre la couche isolante (103) inférieure.

5. Dispositif électronique selon l'une des revendications précédentes, la première région (102A) étant une région d'une couche semi-conductrice (102) du substrat ou reposant sur le substrat.

6. Dispositif électronique selon l'une des revendications précédentes, la première région formant un ilot quantique (QD1 ; QD2).

7. Dispositif électronique selon l'une des revendications précédentes, dans lequel la première région est une région de source ou de drain d'un transistor T₁.

8. Dispositif électronique selon l'une des revendications précédentes, ledit espaceur isolant (141e) étant à base d'un matériau apte à changer, de manière réversible, de résistance et/ou d'état entre une phase amorphe et une phase cristalline, notamment sous l'effet d'un courant électrique.

9. Dispositif électronique selon l'une des revendications 2 ou 3, la première région (102A) étant une région d'une couche semi-conductrice (102), la deuxième région (102A) étant une autre région de ladite couche semi-conductrice (102).

10. Procédé pour la réalisation d'un dispositif microélectronique comprenant les étapes suivantes :
a) prévoir un substrat revêtu d'un empilement comportant une ou plusieurs pistes conductrices (106b) d'un niveau dit « inférieur (M₁, Mₖ) », le niveau inférieur étant revêtu d'une couche isolante (113) dite « intermédiaire », la couche isolante intermédiaire étant revêtue d'une ou plusieurs pistes conductrices d'un niveau dit « supérieur (M₂, Mₖ₊₁) »,
b) formation d'une première ouverture (125b) et d'une deuxième ouverture (125a) dans l'empilement et traversant chacune une piste conductrice (116a, 116b, 116c) du niveau supérieur (M₂, Mₖ₊₁), la couche isolante intermédiaire (113), et une piste conductrice (106a, 206) du niveau inférieur (M₁, Mₖ), la première ouverture (125b) exposant au moins une première portion (1161) et la deuxième ouverture (125a) exposant au moins une deuxième portion (1162) respectivement d'une ou plusieurs pistes conductrices dudit niveau supérieur, la première ouverture (125b) exposant en outre au moins une troisième portion (1061) et la deuxième ouverture (125a) exposant en outre au moins une quatrième portion (1062) respectivement d'une ou plusieurs piste(s) conductrice(s) (106a) dudit niveau inférieur,
c) formation dans la première ouverture (125b) d'un premier espaceur (141e) isolant contre la première portion (1161) de piste conductrice tout en laissant exposée la troisième portion (1061) de piste conductrice et formation dans la deuxième ouverture (125a) d'un deuxième espaceur isolant (131e) contre la quatrième portion (1062) de piste conductrice tout en laissant exposée la deuxième portion (1162) de piste conductrice,
d) remplissage de la première ouverture (125b) et de la deuxième ouverture (125a) par au moins un matériau conducteur (150), de façon à former un premier élément conducteur (156b) et un deuxième élément conducteur (156a), le premier élément conducteur (156b) étant en contact de la troisième portion (1061) tout en étant isolé de la première portion (1161) par le biais du premier espaceur (141e), le deuxième élément conducteur (156b) étant en contact avec la deuxième portion (1162) tout en étant isolé de la quatrième portion (1062) par le biais du deuxième espaceur.

11. Procédé selon la revendication précédente, dans lequel l'étape c), comporte au moins les étapes suivantes :
c1) dépôt d'une première fine couche isolante (131) tapissant les parois de la première ouverture (125b) et de la deuxième ouverture (125a),
c2) gravure partielle de la première fine couche isolante (131) au niveau de ladite partie supérieure de la première ouverture (125b), de sorte à exposer la première portion (1161), tout en préservant la première fine couche isolante au niveau de ladite partie inférieure de la première ouverture ainsi que dans la deuxième ouverture (125a),
c3) gravure partielle de la première portion (1161), de sorte à former une cavité (140),
c4) dépôt d'une deuxième fine couche isolante (141) tapissant les parois de la deuxième ouverture (125a) et de la première ouverture (125b), et remplissant au moins partiellement la cavité (140),
c5) gravure(s) de la deuxième fine couche isolante (141), de sorte à préserver une région (141e) de la deuxième fine couche isolante (141) dans la cavité (140).

12. Procédé selon la revendication 11, dans lequel après l'étape c1) et préalablement à l'étape c2), le procédé comprend les étapes suivantes :
- dépôt d'au moins un matériau (134) de bouchage de la première ouverture (125a) et de la deuxième ouverture (125b),
- formation d'un masquage (138) en regard de la deuxième ouverture (125a) et comportant une fenêtre (139) en regard de la première ouverture (125b),
- gravure, à travers ladite fenêtre (139), dudit au moins un matériau du bouchage (134) dans une partie supérieure de la première ouverture (125b) tout en conservant le matériau du bouchage (134) dans une partie inférieure de la première ouverture (125b), le procédé comprenant en outre, après l'étape c2) et préalablement à l'étape c3) :
- retrait du matériau du bouchage (134) dans la première ouverture (125b) et deuxième ouverture (125a).

13. Procédé selon l'une des revendications précédentes, la première fine couche isolante (131) et la deuxième fine couche isolante (141) étant à base respectivement d'au moins un premier matériau et d'au moins un deuxième matériau différent du premier matériau, l'étape c5) de gravure(s) de la deuxième fine couche isolante (141) étant effectuée par une gravure sélective du deuxième matériau vis-à-vis du premier matériau, suivie d'une gravure anisotrope de la première fine couche isolante.

14. Procédé selon l'une des revendications précédentes, dans lequel le substrat ou l'empilement comporte une couche semi-conductrice (102) revêtue d'au moins une couche isolante (103) dite « inférieure », la couche isolante (103) inférieure étant revêtue par la ou les pistes conductrices du niveau inférieur (M₁, Mₖ) et dans lequel à l'étape b) de formation d'une première ouverture (125b) et d'une deuxième ouverture (125a), la première ouverture (125b) et la deuxième ouverture (125a) sont formées de sorte à traverser la couche isolante inférieure (103) jusqu'à atteindre ladite couche semi-conductrice (102).

15. Procédé selon l'une des revendications précédentes, dans lequel la première ouverture (125b) et la deuxième ouverture (125a) sont formées concomitamment à l'étape b) et dans lequel le remplissage de la première ouverture et de la deuxième ouverture à l'étape d) est avantageusement réalisé de manière concomitante dans la première ouverture et dans la deuxième ouverture.
